(19) Europäisches Patentamt
European Patent Office
Office européen des brevets

(11) Numéro de publication : **0 016 912**
**B1**

(12) **FASCICULE DE BREVET EUROPÉEN**

(45) Date de publication du fascicule du brevet :
22.06.83

(21) Numéro de dépôt : **80100329.4**

(22) Date de dépôt : **23.01.80**

(51) Int. Cl.³ : **H 03 K 17/975**, H 01 H 13/70

(54) **Ensemble de commutateurs pour clavier.**

(30) Priorité : **02.04.79 US 25825**

(43) Date de publication de la demande :
**15.10.80 Bulletin 80/21**

(45) Mention de la délivrance du brevet :
**22.06.83 Bulletin 83/25**

(84) Etats contractants désignés :
**BE CH DE FR GB NL SE**

(56) Documents cités :
**US A 3 584 162**
**IBM TECHNICAL DISCLOSURE BULLETIN,
vol. 21, no. 1, juin 1978 NEW YORK (US) PAUL-
SON et al. : « Electronic keyboard typamatic key
module », pages 244-245**
**IBM TECHNICAL DISCLOSURE BULLETIN,
vol. 20, no. 2, juillet 1977 NEW YORK (US) PARKS
et al. : « Key button module », page 463**
**IBM TECHNICAL DISCLOSURE BULLETIN,
vol. 17, no. 1, juin 1974 NEW YORK (US) FOX :
« Dual-force automatic rekeying » pages 164-165**
**IBM Technical Disclosure Bulletin, vol. 21, no. 9,
février 1979 TM Paulson : « Interchangeable keyboard components », pages 3701-3702**

(73) Titulaire : **International Business Machines Corporation**

**Armonk, N.Y. 10504 (US)**

(72) Inventeur : **Huber, Daniel Lee**
**2425 Shandon Drive**
**Lexington, KY 40505 (US)**
Inventeur : **Paulson, Thomas Michael**
**939 Edgewater Drive**
**Lexington, KY 40502 (US)**
Inventeur : **Williams, James Monroe**
**480 Seeley Drive**
**Lexington, KY 40502 (US)**

(74) Mandataire : **Bonneau, Gérard**
**COMPAGNIE IBM FRANCE Département de Propriété
Industrielle**
**F-06610 La Gaude (FR)**

Ensemble de commutateurs pour clavier

Description

Domaine Technique

La présente invention concerne un ensemble de commutateurs pour clavier et, plus particulièrement un ensemble de commutateurs multiples actionnés au moyen de touches.

Etat de la Technique Antérieure

Les claviers mécaniques pour machines à écrire utilisent des touches qui, lorsqu'elles sont enfoncées à un premier niveau de force, effectuent l'opération d'impression et qui, lorsqu'elles sont enfoncées avec une plus grande force et plus profondément, effectuent une opération d'impression répétée. Ces claviers mécaniques sont maintenant remplacés par des claviers électroniques qui sont moins coûteux et plus fiables. Cependant, il est souhaitable que les claviers électroniques soient tout aussi sensibles à la frappe d'une opératrice et fonctionnent de la même manière que les claviers mécaniques étant donné que la plupart des opératrices ont été formées sur ces anciens types de clavier qui leur sont donc familiers.

Il s'est avéré que les claviers électroniques à couplage capacitif sont meilleur marché et fonctionnent de façon fiable en comparaison des autres claviers électroniques qui emploient des éléments de commutation ohmiques ou par contact du type décrit dans le brevet US-A-3 584 162 où la liaison ohmique a lieu par l'enfoncement pour chaque touche, d'un diaphragme élastique portant une configuration conductrice venant alors en contact avec une seconde configuration conductrice fixe. Un tel clavier à couplage capacitif est par exemple décrit dans l'article « Interchangeable Keyboard Components » paru dans la publication IBM Technical Disclosure Bulletin, Vol. 21, N°. 9, de 1979, pages 3701-3702. Chaque touche comporte des éléments de couplage placés de part et d'autre d'une plaque isolante et un élément de détection. Lors de l'enfoncement de la touche il se produit une modification des capacités formées par les divers éléments entre eux qui est alors détectée par l'élément de détection.

Cependant, les approches faites dans le passé pour obtenir une seconde fonction du commutateur effectuant une impression répétée en même temps qu'une commutation capacitive effectuant la sélection et l'impression des caractères, ont abouti finalement à des dispositifs peu fiables ou des dispositifs qui ne fournissent pas la même réponse tactile et qui ne fonctionnent pas de la même manière que les claviers mécaniques. Des exemples de ces approches sont décrits dans la publication IBM Technical Disclosure Bulletin (TDB) de juin 1974, page 164. Dans ces exemples, il faut que l'opératrice maintienne la touche au-delà d'un temps défini pour effectuer une entrée répétée au clavier ou bien il faut ajouter un mécanisme de commutation supplémentaire. Le mécanisme de commutation supplémentaire décrit dans la publication comporte une cosse de commutation placée sous certaines touches faisant contact avec une plaquette de circuit imprimé lorsque la touche est totalement enfoncée à un second niveau de force. Bien que ce dispositif, du point de vue sensibilité tactile, se comporte comme les claviers mécaniques, il n'est cependant pas fiable étant donné que les contacts des commutateurs risquent de se courber, d'être mal orientés et/ou de mal fonctionner.

Exposé de l'Invention

De manière à résoudre les problèmes de l'art antérieur mentionnés ci-dessus et à fournir un clavier électronique capacitif, fiable, bon marché auquel est associé un ensemble de commutateurs multiples, et qui assure la réponse tactile et le fonctionnement des claviers mécaniques de l'art antérieur, l'invention décrit une structure de clavier unique qui incorpore un ensemble de commutateurs ohmiques placés immédiatement au-dessous des commutateurs capacitifs.

L'ensemble de commutateur pour clavier de l'invention comprend plusieurs touches enfonçables manuellement, et un assemblage de commutation capacitif comprenant une carte de connexion comportant des configurations conductrices distinctes associées à chacune des touches du clavier, une pluralité d'éléments dont chacun est sensible au déplacement d'une touche associée pour se déplacer par rapport à la configuration conductrice associée, et des moyens de détection capacitifs pour détecter un changement de la position relative de certains desdits éléments par rapport aux configurations conductrices associées. Une plaque de commutation est placée au-dessous de la carte de connexion et comprend un élément plan mis à la masse formant un premier élément commutateur et un écran électrique plan pour l'assemblage de commutation capacitif, un second élément commutateur auquel est appliqué un potentiel électrique et des moyens de détection pour détecter le contact entre les éléments commutateurs. Des moyens de contact s'étendent à travers la carte de connexion et permettent le contact des éléments commutateurs lors de l'enfoncement à fond d'une touche associée.

Brève Description des Figures

La figure 1 représente une coupe transversale d'un module de touche en position active.

La figure 2 représente une coupe en perspective d'un module de touche en position de repos.

La figure 3 représente un schéma d'un ensemble de commutateurs pour clavier selon l'invention.

La figure 4 représente un schéma d'une portion de la carte de connexion.

La figure 5 représente un schéma d'une portion de la plaque de commutation.

La figure 6 représente une première réalisation de la plaque de commutation.

La figure 7 représente une deuxième réalisation de la plaque de commutation.

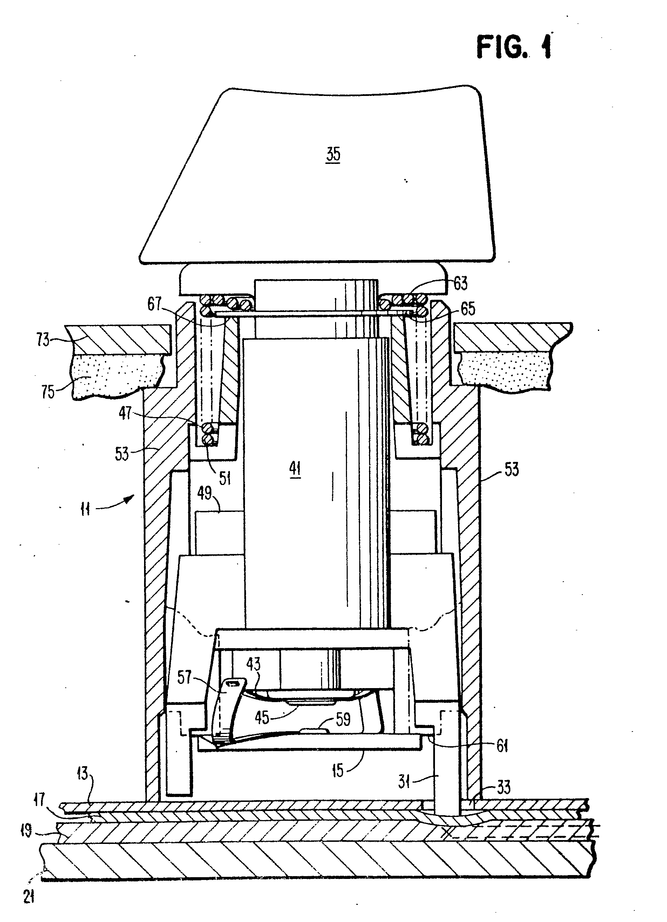

La figure 1 représente une vue en coupe d'un module de touche en position active. Le module de touche 11 repose sur une carte de connexion 13 pourvue de configurations conductrices (non représentées) qui transmettent des signaux électriques indiquant si la plaque mobile 15 repose sur la carte 13 ou s'en trouve écartée. Comme cela sera décrit dans la suite, le mouvement de la plaque mobile lorsqu'elle s'écarte de la carte 13 modifie la capacité de l'ensemble changement qui signale l'actionnement du module 11. Lorsque le module 11 fait partie d'un clavier d'une machine à écrire, le signal indique qu'il faut imprimer un caractère associé ou qu'il faut remplir une fonction associée.

Immédiatement sous la carte de connexion 13, se trouve une couche 17 faite d'un matériau diélectrique. Une plaque de commutation 19 est placée sous la couche 17 et la plaque 19 repose sur le châssis de la machine 21. Comme cela sera décrit dans la suite, la plaque de commutation comprend une surface conductrice (non représentée) qui recouvre toute la surface sous-jacente de la carte 13. Cette surface sert de masse aux commutateurs capacitifs et empêche l'élément de commutation résistif de la plaque de commutation 19 de perturber l'uniformité de la commande de détection de la capacité de la carte 13. En outre, la plaque de commutation 19 comprend une seconde surface conductrice (non représentée) séparée de la surface à la masse, à laquelle est couplée une tension de commutation. Le déplacement de la surface à la masse qui vient en contact physique avec la seconde surface conductrice effectue la fermeture du contact et l'envoi d'un signal comme cela sera décrit dans la suite. Ce déplacement est effectué par la queue 31 du module 11 lorsqu'elle s'abaisse en passant par l'ouverture 33 faite dans la carte 13 pour permettre à la couche 17 de s'infléchir ce qui fait que la surface de masse de la plaque de commutation 19 s'infléchit également dans la surface inférieure mise à la tension.

Le module 11 comprend des mécanismes pour relever la plaque mobile 15 à partir de la carte de connexion 13 et pour abaisser la queue 31 afin d'actionner un commutateur de contact. Le module 11 est construit pour fournir trois niveaux de force distincts qui résistent à l'enfoncement de la touche associée 35. Un premier niveau faible est utilisé pour résister à l'enfoncement de la touche 35 sur une première longueur d'enfoncement initiale faible appelée distance de parcours préalable qui est une indication tactile pour l'opératrice que la touche est en train d'être enfoncée. L'opératrice sait bien que la touche ne va pas être actionnée véritablement durant le parcours de cette distance initiale. Une fois franchi ce parcours préalable, tout enfoncement de la touche 35 rencontre une force résistante plus grande qui indique à l'opératrice que la touche va être actionnée durant ce mouvement, et cet enfoncement de touche correspond au deuxième niveau de force. C'est durant ce mouvement de la touche 35 que la plaque mobile 15 s'écarte de la carte 13. Au cours d'une frappe normale, une fois que la touche a été actionnée, l'opératrice relâche la touche et frappe d'autres touches pour effectuer l'impression. Cependant, lorsqu'il est souhaité, par exemple, imprimer de façon répétée le même symbole, la touche est enfoncée encore davantage pour fermer le commutateur de contact ohmique. Cet enfoncement de la touche correspond au troisième niveau de force.

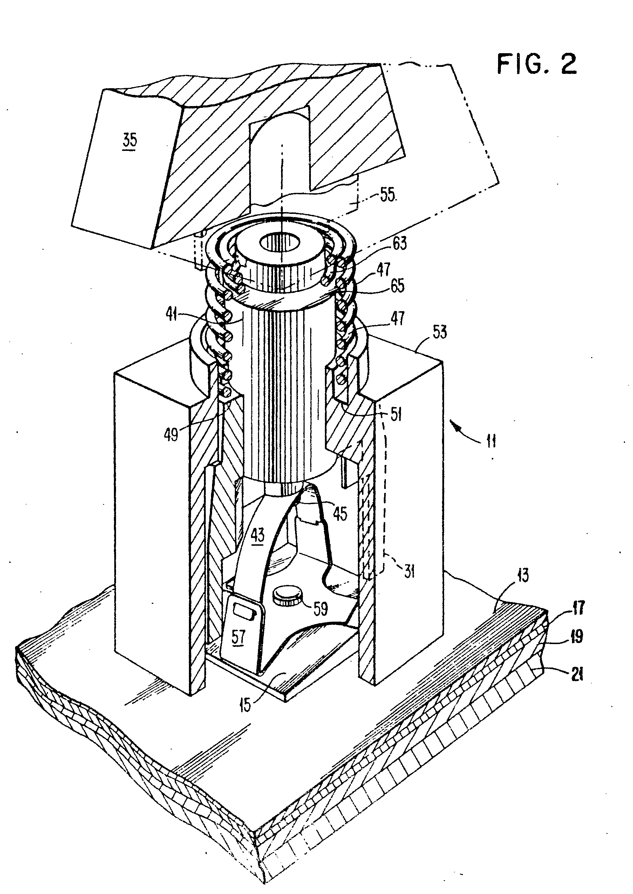

La figure 2 représente une coupe en perspective d'un module de touche en position de repos. L'enfoncement initial de la touche 35 par l'opératrice provoque un mouvement descendant de la tige 41. Le mouvement descendant de cette tige provoque le mouvement descendant du ressort flexible 43 qui lui est physiquement rattaché par le bossage 45 de la tige 41. Lorsque la lame flexible 43 s'incurve vers le bas, elle applique une force résistante à ce fléchissement. Cette force est de l'ordre de 10-20 g. Lorsque la tige 41 a parcouru une distance d'environ 0,09 cm, le ressort de compression 47, qui s'est déplacé avec la tige 41 de la touche vu que ce ressort repose sur la surface 49 de celle-ci et sur une autre surface (non représentée) associée à la queue 31, vient toucher le fond de l'encoche 51 du boîtier 53. A ce moment, une fois parcourue la distance correspondant au parcours préalable, tout mouvement descendant supplémentaire de la touche 35 fait que le ressort de compression 47 se comprime entre le support 55 de la touche et la surface 51 de l'encoche, ce qui fait qu'une force résistante s'ajoute à celle fournie par le ressort flexible 43. La force combinée est de l'ordre de 60 à 85 g. Tout mouvement descendant supplémentaire fait que le ressort flexible 43 s'approche de son point mort et tout léger déplacement au-delà de ce point mort applique une force ascendante sur l'élément flexible 57 et le ressort flexible 43. Le mouvement ascendant de l'élément flexible fait que la plaque mobile 15 rattachée à cet élément par l'écrou 59 s'écarte de la surface de la carte de broches de connexion 13. La distance totale parcourue par la touche à partir du point d'origine est alors d'environ 0,28 cm.

En se reportant à nouveau à la figure 1, la plaque mobile 15 y est montrée en position soulevée. Lorsque la plaque mobile 15 vient en position soulevée, elle fait contact avec la surface d'arrêt 61 du boîtier 53 ce qui l'empêche de s'élever davantage dans le cas où la tige 41 de la touche viendrait à être plus enfoncée. De plus, la surface d'arrêt 61 fixe la position haute de la plaque mobile 15 afin de créer un signal électrique uniforme lorsque la position de la plaque 15 est détectée. Une fois que la plaque mobile 15 vient à occuper sa position haute, la touche 35 peut être enfoncée davantage pour fermer le commutateur résistif de la plaque de commutation 19. Cet enfoncement supplémentaire de la touche 35 fait que la tige 41 et la queue 31 de cette tige se déplacent davantage vers le bas. Ce mouvement descendant est contré par une force fournie par le ressort de compression 47 et une autre force fournie par le ressort de compression conique 63.

Le ressort de compression conique 63 repose sur une rondelle 65 qui glisse sur la tige 41. Lorsque la tige de la touche a parcouru une distance d'environ 0,4 cm, la rondelle 65 vient s'appuyer contre la surface 67 du boîtier 53. A ce moment, le ressort 63 commence à créer une force résistante au fur et à mesure qu'il est comprimé. La force supplémentaire créée par les ressorts 63 et 47 est d'environ 510 à 850 g.

La queue 31 de la tige vient en contact avec la couche 17 une fois qu'elle a parcouru environ 0,1 cm à la suite de l'actionnement du ressort de compression conique 63. Lorsque la touche 35 a parcouru une distance d'environ 0,5 cm, le contact ohmique de la carte de commutation 19 fournit un second signal électrique de sortie.

Lorsque l'opératrice relâche la touche 35, le ressort de compression conique 63 et le ressort de compression 47 provoquent le mouvement ascendant de la tige 41. Lorsque le ressort flexible 43 rattaché à la tige 41 a atteint son point mort, la force qu'il exerce ajoutée à celle du ressort de compression 47, fait que le système repasse à sa position initiale, comme le montre la figure 2.

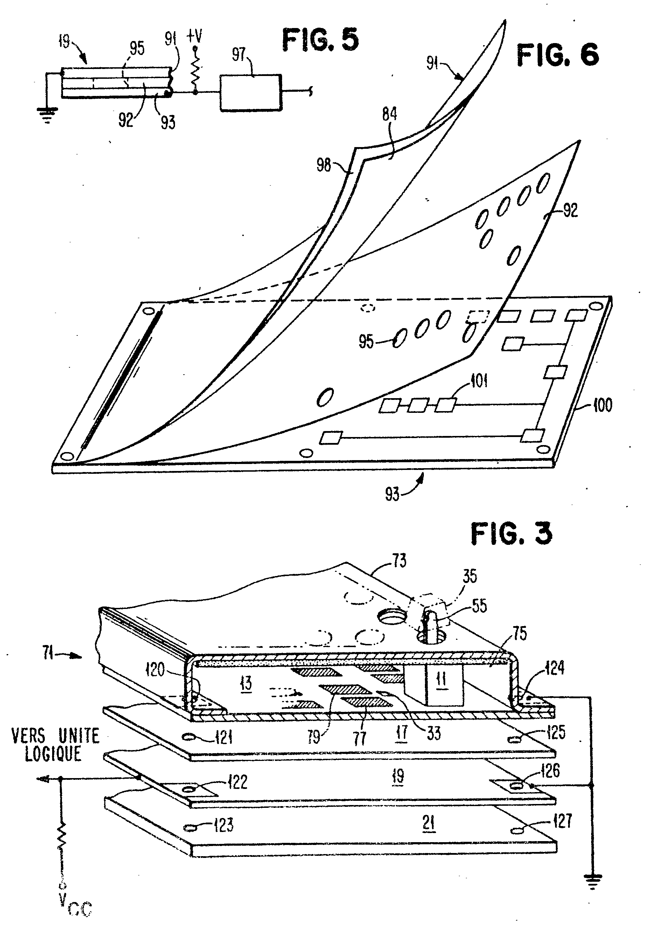

La figure 3 représente schématiquement une partie d'un clavier. La partie de clavier 71 comprend plusieurs modules de touche 11 qui reposent sur la carte de connexion 13. Les modules 11 peuvent être identiques entre eux ou quelques-uns peuvent être dépourvus de la tige 31 de la figure 1 ainsi que du ressort de compression conique 63 et de la rondelle 65. En outre, l'ensemble 71 comporte la couche 17, la plaque de commutation 19 et le châssis 21 qui supporte l'ensemble. De plus, une plaque 73 est utilisée pour supporter les modules de touche 11 et comprend une couche de mousse 75 pour réduire les bruits acoustiques et empêcher toute contamination due à des impuretés. La couche de mousse 75 maintient également les modules 11 contre la carte de connexion 13 afin d'assurer un espacement constant et uniforme entre la plaque mobile 15 (figure 1) et la carte 13. Les touches 35 sont attachées au support 55 une fois monté l'ensemble du clavier. Comme le montre la figure, chaque module de touche 11 repose sur une plaque de détection 77 et une plaque de couplage 79 qui sont des éléments du circuit imprimé de la carte de connexion 13. Les circuits électriques formés par ces éléments de circuit vont faire l'objet de la description qui suit.

La figure 4 représente schématiquement une portion de la carte de connexion et du plan de masse. La carte de connexion 13 comprend un substrat 81 fait dans un matériau isolant, par exemple, un matériau fait de résine époxy et fibres de verre. Sur le substrat 81 se trouvent plusieurs contacts de détection 77, contacts de couplage 79 et contacts de commande 83, chacun de ces contacts étant illustré sur la figure. La plaque mobile 15 du module 11 de la figure 1 repose sur un contact de détection 77 et sur un contact de couplage 79 correspondant séparé par une couche isolante de résine époxy (non représentée). La plaque mobile 15 est faite dans une matière plastique conductrice, par exemple, du nylon imprégné de graphite alors que le contact de détection, le contact de couplage, et le contact de commande sont en cuivre. La couche 17 de matériau diélectrique et un plan de masse 84 sont placés au-dessous de la carte de connexion 13. En outre, une connexion à la masse 85 et une connexion à la masse 86, chacune en cuivre, sont placées de chaque côté du contact de commande 83 de la carte de connexion 13.

Dans la structure représentée, il existe une capacité de couplage C1 entre le contact de couplage 79 et le contact de commande 83, une capacité de couplage C2 entre la plaque mobile 15 et le contact de détection 77 et une capacité de couplage C3 entre le contact de couplage 79 et la plaque mobile 15. La couche 17 faite dans un matériau diélectrique et le plan de masse 84 sont essentiels pour réduire au maximum la capacité parasite existant entre les divers éléments et contacts de commutation.

Pour détecter la position de la plaque mobile 15 et, partant, savoir si la touche 35 a été enfoncée, un dispositif de commande de tension 87 est utilisé pour envoyer périodiquement une impulsion de tension au contact de commande 83. Cette impulsion de tension fait qu'un courant circule depuis le contact de détection 77 jusqu'au dispositif de détection 89. Ce courant peut être représenté par l'équation :

$$I = CdV/dt$$

où dv/dt définit la transition de tension du dispositif de commande de tension 89, et C est donné par l'équation

$$1/C = 1/C1 + 1/C2 + 1/C3$$

Dans le dispositif représenté, la capacité passe d'environ 4 pico-farads à environ 0,4 pico-farads lorsque la plaque mobile 15 s'élève, ce qui fait qu'il y a changement des capacités C2 et C3.

En outre, il faut garder à l'esprit qu'il existe plusieurs commutateurs capacitifs adjacents sur le substrat 13, dont un pour chaque module de touche. Etant donné qu'il est utilisé, avec le clavier, un dispositif de commande commun à seize sorties et un dispositif de détection commun à quatre entrées, il est nécessaire que chaque commutateur capacitif associé à chaque module de touche engendre approximativement le même signal de sortie. Les connexions à la masse 85 et 86 placées de chaque côté du contact de commande 83 servent d'éléments de protection entre contact de commande 83 des éléments de commutation capacitifs adjacents. Comme cela est décrit, le plan de masse 84 est placé très proche de la carte de connexion 13 et sert à réduire la capacité parasite et à assurer l'uniformité de chaque commutateur capacitif étant donné qu'il est parallèle à la carte de connexion 13 et présente le même potentiel de référence en tous ses points. Les circuits de commande et de détection sont semblables à ceux décrits dans le brevet des E.U.A. N° 3 786 497.

Comme cela a été mentionné préalablement, un commutateur de contact résistif est placé sous la carte de connexion 13 et est actionné par les modules de touche dont la tige a une queue 31 (voir figure 1). Le fonctionnement de ce commutateur va être décrit immédiatement dans la suite.

La figure 5 représente schématiquement une portion de la plaque de commutation. La plaque de commutation 19 comprend un élément supérieur à la masse 91, un élément de séparation isolant 92 et un élément inférieur 93 auquel est appliquée une source de tension. Le séparateur 92 est pourvu d'ouvertures 95 qui correspondent chacune à l'emplacement où la queue 31 (voir figure 1) peut incurver l'élément supérieur 91. Lorsque l'élément supérieur 91 fait physiquement contact avec l'élément inférieur 93, le potentiel de terre est appliqué à l'élément inférieur 93 ce qui fait que le dispositif de détection 97 peut détecter le changement du niveau de tension et engendre un signal correspondant qui peut être utilisé par une unité logique, ou tout élément semblable. Ce signal peut être utilisé pour provoquer une opération cyclique continue d'une imprimante ou peut être utilisé pour placer un système de traitement de mots en mode de fonctionnement spécial (par exemple, centrage d'un texte, justification d'un texte, etc.).

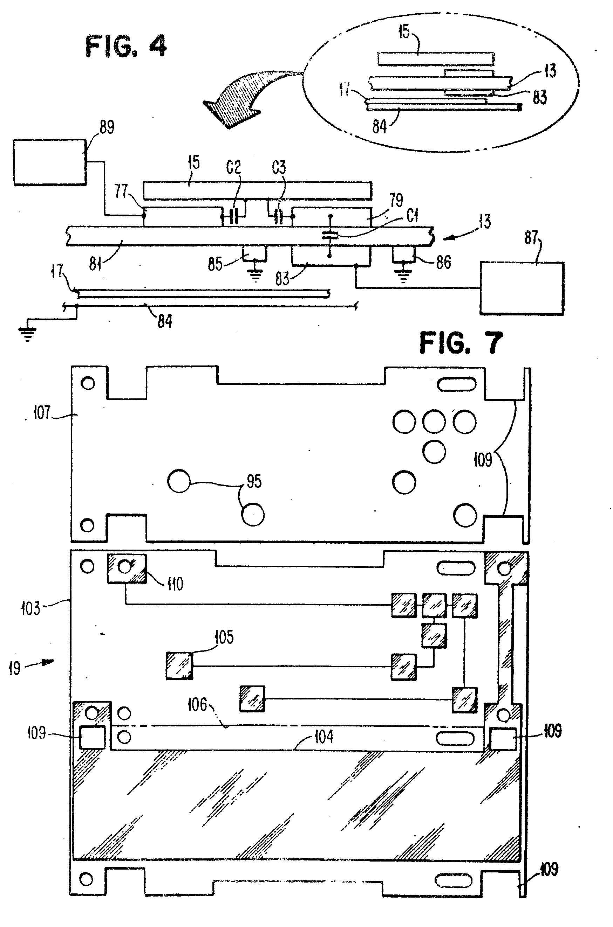

La figure 6 illustre la plaque de commutation 19 avec l'élément inférieur 93, le séparateur 92 et l'élément supérieur 91. L'élément supérieur 91 est fait d'une mince feuille de téréphtalate de polyéthylène 98 revêtue d'une couche de charbon, ou plan de masse 84. Cette surface 84 est électriquement connectée à la masse et forme un plan de masse 84 pour la carte 13 de la figure 4 comme cela a été décrit préalablement ; cette surface est également une portion de l'élément commutateur supérieur 91 du commutateur de contact résistif de la figure 5.

Le séparateur 92 peut également être fait dans du téréphtalate de polyéthylène et il est pourvu d'ouvertures 95 faites aux positions correspondant aux modules de touche qui ont une queue 31 à leur tige (figure 1). L'élément inférieur 93 comprend une plaquette rigide 100 sur laquelle sont placées des contacts de cuivre 101 qui correspondent aux emplacements où se trouvent les ouvertures 95. Une tension est appliquée à ces contacts de cuivre comme cela a été décrit en référence à la figure 5 des dessins. La commutation se fait lorsque la surface revêtue de charbon 84 vient en contact avec un contact de cuivre 101 ce qui le met à la masse. Il est à noter que plusieurs circuits de détection pourraient être séparément couplés à chacun des contacts de cuivre 101 afin de fournir des signaux de sortie uniques pour chaque touche correspondante ou pour des groupes de touches correspondants, ou bien un seul circuit pourrait être utilisé pour toutes les touches.

On va se reporter à nouveau à la figure 3 à l'aide de laquelle a été décrit le fonctionnement des commutateurs placés sur la carte de connexion 13 et ceux placés sur la plaque de commutation 19. Comme cela a été indiqué préalablement, la couche 17 faite dans un matériau diélectrique est placée entre la carte 13 et la plaque 19. Ce matériau diélectrique peut être du chlorure de polyvinyle dont la constante diélectrique est d'environ 3,5 à 4, et la dureté Shore égale à 80. Le choix de la constante diélectrique est important pour assurer une capacité parasite minimale, comme cela a été expliqué préalablement. La dureté est importante dans la détection du contact tactile et permet une flexion appropriée lorsque la queue 31 de la tige (voir figure 1) est actionnée. Comme cela a été mentionné, cette couche sert à assurer la réduction de la capacité parasite et sert également à propager la force appliquée sur le commutateur de contact résistif. C'est-à-dire, en référence à la figure 1, lorsque la queue 31 de la tige se déplace vers le bas, ce déplacement fait que la touche 17 s'infléchit dans le commutateur de contact résistif, ce qui fait que la force qui va lui être appliquée se répartit sur une plus grande surface, et de ce fait, les éléments de commutation font contact sur une plus grande surface.

La figure 7 illustre une autre réalisation possible de la plaque de commutation. La plaque de commutation 19 comprend un substrat de téréphtalate de polyéthylène 103 qui supporte une couche revêtue de charbon 104 ainsi qu'une configuration revêtue de cuivre 105. Le substrat 103 est plié le long de la ligne 106 et une couche de séparation 107 pourvue d'ouvertures 95 est insérée à la pliure. Le commutateur fonctionne de la façon décrite préalablement en référence à la figure 6 et la surface revêtue de charbon 104 forme un élément commutateur ainsi qu'un plan de masse pour les commutateurs capacitifs.

En se reportant à nouveau à la figure 4, il est à noter que le potentiel de terre du plan de masse 84 et le potentiel de terre des connexions à la masse 85 et 86 doivent être les mêmes. Ainsi, est-il nécessaire d'assurer une bonne connexion physique entre les éléments mis à la masse placés sur la carte de connexion 13 et le plan de masse 84 de l'élément de commutation. En se reportant à nouveau à la figure 7, cette connexion peut se faire à l'aide d'un connecteur métallique inséré dans les ouvertures 109. Le contact pour assurer la mise sous tension se fait par le contact 110.

En se reportant à nouveau à la figure 3, l'ensemble 71 de la portion de clavier est monté en plaçant les modules de touche 11 sur les positions appropriées de la carte de connexion 13. Les modules 11 peuvent être soit du type représenté sur les figures 1 et 2 c'est-à-dire pourvus d'une queue 31 qui passe dans une ouverture 33, soit du type qui ne possède pas de queue de tige. Une fois les modules 11 assemblés sur la carte 13, la plaque 73 sur laquelle se trouvent les touches est placée sur la carte de connexion alors que la couche 17, la plaque de commutation 19 et le châssis 21 sont assemblés sous cette carte. Un fil conducteur (non représenté) est connecté par les trous d'assemblage 120-123 et 125-127.

En référence à nouveau à la figure 1, l'enfoncement de la touche 35 provoque le mouvement descendant de la tige 41, ce qui force la lame flexible 43 à subir également un mouvement descendant. Une fois parcourue la distance correspondant au trajet préalable, la force résistante du ressort de compression 47 s'ajoute à celle de la lame flexible 43 pour contrer le mouvement descendant de la touche 35. Lorsque la lame flexible 43 atteint sa position centrale, son action ajoutée à celle du ressort 57 font que la plaque mobile 15 s'écarte de la carte de connexion 13. Tout autre mouvement descendant est contré par le ressort de compression conique 63. Tout enfoncement plus avant de la touche 35 entraîne la queue 31 de la tige à appliquer la couche 17 contre la surface supérieure de la plaque de commutation 19. Un commutateur de contact peut être ajouté sur la plaque de commutation 19 pour fournir un signal de sortie électrique.

En référence aux figures 4 et 5, le déplacement de la plaque mobile 15 qui s'écarte alors de la plaque 13 modifie les capacités C2 et C3. Ce changement de capacité est détecté par le dispositif de détection 89 lors de l'application de l'impulsion de tension sur le contact de commande 83, par le dispositif de commande de tension 87. Le signal engendré par le dispositif de détection 89 peut être utilisé pour effectuer l'impression lorsque le dispositif est utilisé simultanément avec une imprimante. Ainsi, un caractère particulier associé à chaque module de touche est imprimé par enfoncement de sa touche associée. La sortie du dispositif de détection 89 pourrait également être utilisée pour effectuer une fonction d'impression par exemple, un espacement, un interlignage, un retour de chariot, etc..

L'enfoncement de la touche 35 de la figure 1 sur sa position la plus basse fait que l'élément de commutation supérieur mis à la masse 91 passe par l'ouverture 95 du séparateur 92 ce qui fait que l'élément 93 de la plaque de commutation 19 est mis à la masse. Cette action est détectée par le dispositif de détection 97 et fournit un signal de sortie continu aussi longtemps que la touche 35 de la figure 1 est maintenue dans cette position. Le signal peut être utilisé par une unité logique pour effectuer le cyclage continu du mécanisme d'impression afin d'imprimer le caractère sélectionné par l'élément de commutation capacitif. Ce signal pourrait également être utilisé pour effectuer une fonction de machine unique, par exemple, pour placer la machine à écrire sur un mode de fonctionnement spécial (par exemple, une justification, un centrage, etc.).

Il est à noter que le mode de fabrication du commutateur capacitif peut varier. C'est-à-dire, un seul ressort à flexion rattaché à une feuille mobile pourrait être employé à la place de la combinaison d'éléments flexibles telle qu'elle est utilisée ici. Ce ressort à flexion est décrit dans le brevet des E.U.A. N° US-A 4 118 611.

**Revendications**

1. Ensemble de commutateurs pour clavier, comprenant plusieurs touches (35) enfonçables manuellement, et un assemblage de commutation capacitif comportant une carte de connexion (13) comportant des configurations conductrices distinctes (79) associées à chacune des touches, une pluralité d'éléments (15) dont chacun est sensible au déplacement d'une touche associée pour se déplacer par rapport à ladite configuration conductrice associée, et des moyens de détection capacitifs (77) pour détecter un changement de la position relative de certains desdits éléments par rapport aux configurations conductrices associées ; ledit ensemble étant caractérisé en ce qu'il comprend :
une plaque de commutation (19) placée au-dessous de ladite carte de connexion, comprenant un élément plan (91) mis à la masse formant un premier élément commutateur et un écran électrique plan à la masse pour ledit assemblage de commutation capacitif, un second élément commutateur (93) auquel est appliqué un potentiel électrique, et des moyens de détection (97) pour détecter le contact entre lesdits premier et second éléments commutateurs,
des moyens de contact (31) s'étendant à travers ladite carte de connexion et étant sensibles à l'enfoncement à fond d'une touche associée pour permettre le contact entre lesdits premier et second éléments commutateurs.

2. Ensemble de commutateurs selon la revendication 1 caractérisé en ce qu'il comprend en outre :
des premiers moyens (43) opposant une résistance à l'enfoncement de la touche associée sur une première longueur d'enfoncement,
des deuxièmes moyens (47) opposant une résistance à l'enfoncement de la touche associée sur une deuxième longueur d'enfoncement à partir de ladite première longueur d'enfoncement,
des troisièmes moyens (63) opposant une résistance à l'enfoncement de la touche associée sur une troisième longueur d'enfoncement à partir de ladite deuxième longueur d'enfoncement.

3. Ensemble de commutateurs selon la revendication 2 caractérisé en ce que ladite troisième longueur d'enfoncement débute lorsque se produit le changement dans la position relative entre ledit élément (15) et la configuration conductrice associée (79).

4. Ensemble de commutateurs selon la revendication 1, 2 ou 3 caractérisé en ce qu'il comprend en outre un élément plan (17) électriquement isolant entre ladite carte de connexion (13) et ladite plaque de commutation (19) de façon à réduire la capacité parasite de ladite plaque de commutation ; lesdits moyens de contact (31) venant en contact avec ledit élément isolant lors de l'enfoncement de la touche (35) associée et permettant de la sorte l'application d'une force permettant le contact entre lesdits premier (91) et second (93) éléments commutateurs.

## Claims

1. Assembly of keyboard switches, including several manually operated keys (35) and a capacitive switching assembly, including a connection board (13) with discrete conductive configurations (79) associated with each of the keys, a plurality of elements (15), each of which is sensitive to the movement of one associated key to move with respect to said associated conductive configuration, and means of capacitive detection (77) to detect a change in the relative position of certain said elements with respect to the associated conductive configurations ; said assembly being characterized in that it includes :

a switching plate (19) located below said connection board, comprised of a grounded flat part (91), forming a first switching element, and a flat grounded electrical screen for said capacitive switching assembly, a second switching element (93) to which is applied an electrical potential, and means of detection (97) to detect the contact between said first and second switching elements ;

means of contact (31) extending across said connection board and being sensitive to the full depression of an associated key to allow the contact between said first and second switching elements.

2. Assembly of switches in accordance with claim 1, characterized in that it also includes :

first means (43) resisting the depression of the associated key over a first segment of depression,

second means (47) resisting a further depression of the associated key over a second depression segment, starting from the end of said first segment,

third means (63) resisting a further depression of the associated key over a third depression segment, starting from the end of said second segment.

3. Assembly of switches in accordance with claim 2, characterized in that said first depression segment starts when the change in the relative position between said element (13) and the associated conductive configuration (79) occurs.

4. Assembly of switches in accordance with claims 1, 2 or 3, characterized in that it also includes a flat electrically insulating part (17) between said connection board (13) and said switching plate (19), so as to reduce the spurious capacitance of said switching plate ; said means of contact (31) coming into contact with said insulating part when the associated key (35) is depressed and thus enabling the application of a force allowing the contact to be established between said first (91) and second (93) switching elements.

## Ansprüche

1. Schalteranordnung für ein Tastenfeld, bestehend aus mehreren manuell betätigbaren Tasten (35) und einer kapazitiven Schaltereinheit mit einer Verbindungskarte (13), die verschiedene, den einzelnen Tasten zugeordnete Leiteranordnungen (79) enthält, mit einer Anzahl von Elementen (15), von denen jedes auf die Betätigung einer zugeordneten Taste durch Verschieben gegenüber dem zugeordneten Leiter anspricht, sowie mit kapazitiven Abtastmitteln (77) zum Abtasten einer Änderung der jeweiligen Stellung der genannten Elemente in Bezug auf die zugeordneten Leiteranordnungen, dadurch gekennzeichnet,

daß eine über der genannten Verbindungskarte angeordnete Umschaltplatte (19) mit einem ebenen Element (91) vorgesehen ist, wobei das ebene Element an Masse liegt und ein erstes Schaltelement bildet, sowie ein ebener elektrischer Schirm an der Masse für die genannte kapazitive Schalteinheit, und daß ein zweites Schaltelement (93) vorgesehen ist, an das ein elektrisches Potential gelegt ist, sowie Abtastmittel (97) für den Kontakt zwischen den genannten ersten und zweiten Schaltelementen, und

daß durch die Verbindungskarte verlaufende Kontaktelemente (31) vorgesehen sind, die auf die vollständige Betätigung einer zugeordneten Taste ansprechen und den Kontakt zwischen dem genannten ersten und zweiten Schaltelement herstellen.

2. Schalteranordnung nach Anspruch 1, dadurch gekennzeichnet, daß sie außerdem enthält :

erste Mittel (43), die dem Betätigen der zugeordneten Taste über einen ersten Betätigungshub hinaus einen Widerstand entgegensetzen,

zweite Mittel (47), die dem Betätigen der zugeordneten Taste über einen zweiten Betätigungshub hinaus, ausgehend von dem ersten Betätigungshub, einen Widerstand entgegensetzen, und

dritte Mittel (63), die dem Betätigen der zugeordneten Taste über einen dritten Betätigungshub, ausgehend von dem zweiten Betätigungshub, einen Widerstand entgegensetzen.

3. Schalteranordnung nach Anspruch 2, dadurch gekennzeichnet, daß der dritte Betätigungshub beginnt, sobald die Änderung der Relativlage zwischen dem genannten Element (15) und der zugeordneten Leiteranordnung (79) beginnt.

4. Schalteranordnung nach Anspruch 1, 2 oder 3, dadurch gekennzeichnet, daß zusätzlich ein ebenes, elektrisch isolierendes Element (17) zwischen der Verbindungkarte (13) und der Umschaltplatte (19) angeordnet ist, um die Störkapazität der genannten Umschaltplatte zu verringern, und daß die Kontaktelemente (31) beim Betätigen der zugeordneten Taste (35) in Kontakt gelangen und auf diese Weise die Einwirkung einer Kraft zur Herstellung des Kontakts zwischen dem ersten (91) und dem zweiten Schaltelement (93) ermöglichen.

**FIG. 1**

FIG. 2

**FIG. 5**

**FIG. 6**

**FIG. 3**

VERS UNITE
LOGIQUE

$V_{CC}$

3

## FIG. 4

## FIG. 7